Europäisches Patentamt

(19) European Patent Office

Office européen des brevets

(11) Publication number : **0 443 835 B1**

## (12) EUROPEAN PATENT SPECIFICATION

(45) Date of publication of patent specification :
27.12.95 Bulletin 95/52

(51) Int. Cl.⁶ : **G01R 27/26, G01R 17/10, G01R 31/02**

(21) Application number : **91301344.7**

(22) Date of filing : **20.02.91**

(54) **Circuit element measuring apparatus and method**

(30) Priority : **21.02.90 JP 40559/90**

(43) Date of publication of application :
**28.08.91 Bulletin 91/35**

(45) Publication of the grant of the patent :
**27.12.95 Bulletin 95/52**

(84) Designated Contracting States :
**DE FR GB**

(56) References cited :
**EP-A- 0 349 168**
**HEWLETT-PACKARD JOURNAL. vol. 30, no. 2, February 1979, PALO ALTO US pages 24 - 31; MAEDA & NARIMATSU: 'MULTI-FREQUENCY LCR METERS...'**
**PATENT ABSTRACTS OF JAPAN vol. 14, no. 160 (P-1028)(4103) 28 March 1990**

(73) Proprietor : **Hewlett-Packard Company**
**P.O. Box 10301**
**3000 Hanover Street**
**Palo Alto California 94303-0890 (US)**

(72) Inventor : **Wakamatsu, Hideki**
**Mizoguchi Haitsu 301,**
**3-18-24, Owadacho**
**Hachiojishi, Tokyo (JP)**
Inventor : **Goto, Shinya**
**YHP Dai 2 Dokushinryo,**
**12-9, Takakuracho**
**Hachiojishi, Tokyo (JP)**

(74) Representative : **Colgan, Stephen James et al**
**CARPMAELS & RANSFORD**
**43 Bloomsbury Square**
**London WC1A 2RA (GB)**

EP 0 443 835 B1

## Description

### Field of the Invention

The present invention relates to a method and apparatus for high accuracy circuit element measurements by easily correcting changes, if any, in the measurement cables or range resistance. A method according to the preamble of claim 8 and an arrangement according to the preamble of claims 1 and 6 are e.g. known from the Hewlett Packard Journal, vol. 30, nº 2, February 1972, Palo Alto, VS, pages 24-31, K. Maeda and Y. Narimatsu, "Multi-Frequency LCR Meters Test Components under Realistic Conditions".

### Background of the Invention

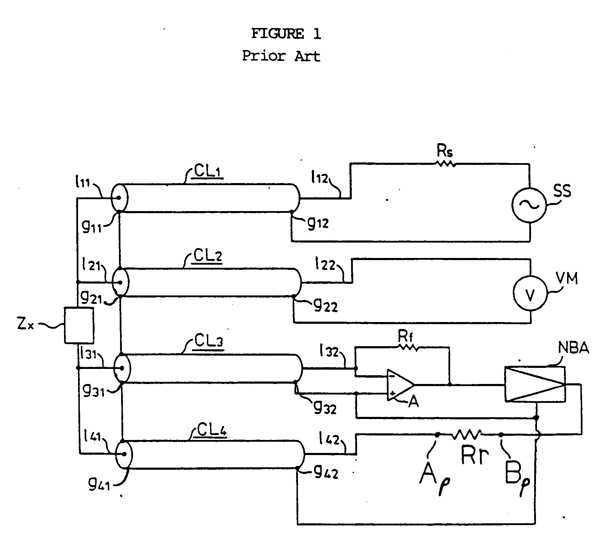

Demands for high-precision measurements of a circuit element are increasing annually. The apparatus for such measurements is exemplified by the "Multi-Frequency LCR meter 4274A or 4275A" which is commercially available from Yokogawa-Hewlett-Packard for use in four-terminal measurements. Fig. 1 is a schematic circuit diagram showing a circuit element measuring apparatus for four-terminal pair measurements according to the prior art.

By means of four terminal lines $CL_1$, $CL_2$, $CL_3$, and $CL_4$ providing four terminal pairs, a circuit element to be measured (hereinafter referred to as a "DUT" or element $Z_x$) is connected to a signal source SS, a volt meter VM, range resistance $R_r$ and zero detection amplifier A which together form a measuring apparatus. The impedance value of the element $Z_x$ shall also be referred to as $Z_x$.

The lines $CL_1$, $CL_2$, $CL_3$ and $CL_4$ are generally made of coaxial cables although not limited thereto, and their outer conductor terminals $g_{11}$, $g_{21}$, $g_{31}$ and $g_{41}$ at one end thereof are connected to one another and held at the same potential. The terminals $\ell_{11}$ and $\ell_{21}$ of the center conductor of the lines $CL_1$ and $CL_2$ at the same end thereof are connected to one terminal of the element $Z_x$. The terminals $\ell_{31}$ and $\ell_{41}$ of $CL_3$ and $CL_4$ are connected to the other terminal of the element $Z_x$. The terminals of the center conductors of the lines $CL_1$, $CL_2$, $CL_3$, and $CL_4$ and the outer conductor at the opposite end (i.e. at the side on the meter) are respectively designated as $\ell_{12}$, $g_{12}$, $\ell_{22}$, $g_{22}$, $\ell_{32}$, $g_{32}$, $\ell_{42}$ and $g_{42}$.

Between the terminals $\ell_{12}$ and $g_{12}$, the signal source SS and a signal source resistance $R_s$ are connected in series. The volt meter VM is connected between the terminals $\ell_{22}$ and $g_{22}$. The terminals $\ell_{32}$ and $g_{32}$ are respectively connected to the inverted input terminal and non-inverted input terminal of the zero detection amplifier A. The feedback resistance $R_f$ is connected between the inverted input terminal and the output terminal of the zero detection amplifier A. The output of the zero detection amplifier A is introduced into a narrow-band amplification/phase compensation amplifier NBA. The output of the NBA is applied through the range resistance $R_r$ to the terminal $\ell_{42}$. The NBA is similar to that used in the aforementioned meters 4272A and 4275A. The range resistance $R_r$ is placed between the terminal $\ell_{42}$ and the NBA output, and the terminals $g_{42}$ and $g_{32}$ are also connected.

In the circuit of Fig. 1, an automatic control is performed on the voltage between the terminals $\ell_{32}$ and $g_{32}$, i.e., controlled such that the current flow through the terminal $\ell_{32}$ may be substantially zero. As a result, a voltage $V_x$ to be applied to the element $Z_x$ is obtained as the indication of the volt meter VM. Moreover, a current $I_x$ to flow through the element $Z_x$ is obtained as an indication of the range resistance $R_r$. Since a complex voltage and a complex current are measured at the volt meter VM and the range resistance $R_r$ with reference to the detected output of the signal source SS, the value $Z_x$ is determined in a complex value in accordance with the following equation:

$$Z_x = V_x/I_x = V_x R_r/V_i \quad (0),$$

wherein $V_i$ is equal to the voltage generated across the $R_r$ and is expressed as

$$V_i = I_x R_r.$$

In the above-equation, the term $V_x/V_i$ is calculated by a well known vector voltage measuring circuit (referred to as "VRD") which is incorporated in the aforementioned meters 4274A and 4275A. The calibrations are accomplished by the well known method of shorting and opening elements (or by using a known third impedance) to replace the elements to be measured. However, due to a host of inaccuracies in the apparatus, the accurate value as expressed by the Equation (0) cannot always be obtained.

Specifically, the voltage $V_v$ measured by the volt meter VM is different from the voltage $V_x$ applied to the DUT. The voltage $V_i$ across the range resistor $R_r$ is also different from the product of the current $I_x$ through the DUT and the resistance $R_r$. Moreover, the values $V_x$ and $V_v$ and the values $I_x$ and $V_i$ are respectively proportional to individual coefficients which are a function of angular frequency $\omega$, so that they can be expressed as follows:

$$V_x = H(\omega) V_v \quad (1);$$

and

$$I_x = Y(\omega) V_i \quad (2).$$

Hence, the impedance $Z_x$ of the DUT is expressed, as follows:

$$Z_x = V_x/I_x$$
$$= (H(\omega))/(Y(\omega)) (V_v/V_i)$$
$$= Z_c(\omega) (V_v/V_i) \quad (3),$$

wherein

$$Z_c(\omega) = H(\omega)/Y(\omega) \quad (3 - 1).$$

The vector ratio of $V_v/V_i$ can be accurately measured by the VRD. A known standard $Z_R$ is measured in advance in place of an unknown DUT, and the $Z_c(\omega)$ is calculated as a correction data from the measured vector ratio $(V_v/V_i)$ and the value $Z_R$. The calculated value of $Z_c(\omega)$ is stored in the apparatus. Thus, when the impedance $Z_x$ of an unknown DUT is to be measured, the vector ratio $(V_v/V_i)$ is measured and multiplied by the correction data $Z_c(\omega)$.

Incidentally, in order to measure the DUT remotely or in combination with another apparatus, the impedance measuring apparatus should be able to use various cable lengths $\ell$. In order to obtain the impedance of the DUT with an optimal signal to noise or S/N ratio, a plurality of range resistors $R_r$ may be used.

From the standpoint of the S/N ratio, it is necessary to use the $Z_R$ having a value suited for the range resistance $R_r$. It is also necessary to change the standard apparatus for each range resistance $R_r$ when the correction data $Z_c(\omega)$ is to be obtained. However, $Z_c(\omega)$ is a function of cable length $\ell$ and range resistor $R_r$. Therefore, it is generally necessary to measure and store the correction data $Z_c(\omega)$ for all conceivable combinations of the value $R_r$ and $\ell$.

One conceivable solution is to determine the data $Z_c(\omega)$ from separable and independent functions of the cable length $\ell$ and the range resistance $R_r$. The concept that the data $Z_c(\omega)$ is determine for separable and independent functions of the cable length $\ell$ and the range resistor $R_r$ means that the value $Z_c(\omega)$ can be expressed in the form of the product of a function $z1(\ell)$ of $\ell$ and a function $z2(R_r)$ of $R_r$ by the following Equation:

$$Z_c(\ell, R_r, \omega) = z1(\ell, \omega) z2(R_r, \omega) \quad (4)$$

The circuit measuring apparatus satisfying the above-specified definition has the following advantages:

(a) If the following three values are known for the cable lengths $\ell_1$ and $\ell_2$ and the range resistances $R_r1$ and $R_r2$, the correction data $Z_c(\omega)$ need not be measured for all combinations of $\ell$ and $R_r$:

$$Z_c(\ell_1, R_r1, \omega) ;$$
$$Z_c(\ell_1, R_r2, \omega) ;$$

and

$$Z_c(\ell_2, R_r1, \omega) ,$$

Other correction data can be calculated in the following form:

$$Z_c(\ell_2, R_r2, \omega) = z1(\ell_2, \omega) z2(R_r, \omega)$$
$$= z_c(\ell_1, R_r2, \omega) \cdot z_c(\ell_2, R_r1, \omega)/z_c(\ell_1, R_r1, \omega) \quad (5).$$

In other words, the combination of the correction data to be measured is reduced as follows:

from (the number of $\ell$) x (the number of $R_r$) when the value $Z_c$ is not separable;

to (the number of $\ell$) + (the number of $R_r$) - 1, when the value $Z_c$ is separable. As a result, the time for measuring the correction data is substantially reduced.

(b) After the correction data have been measured for one cable length $\ell$ and all the range resistances $R_r$, a correction data is measured for a new cable length. In this case, the correction data is measured for only one range resistance $R_r$, and can be calculated from the Equation (5) for the remaining range resistance, as described in the advantage (a). In other words, the measurement of the correction data $Z_c(\omega)$ for a new cable length may be only once by using one standard apparatus even if the range resistance $R_r$ is varied.

Generally speaking, the reference resistance $R_R$ is used in the reference apparatus $Z_R$. This means that the correction data can be easily calculated even when an arbitrary cable length $\ell$ is used.

In order to achieve the advantages heretofore described, there may be several methods of making the $Z_c(\omega)$ separable. The circuit shown in Fig. 1 satisfies the separation of the value $Z_c(\omega)$. At point A in Fig. 1, the potential is substantially zero for a low measuring frequency signal. However, when the frequency is high, the potential at point $A_p$ in Fig. 1 is not substantially zero. In an extreme case, the potential at $A_p$ may become equal to the potential at $B_p$ in Fig. 1 as the measuring frequency or the measuring cable length $\ell$ greatly increases. Whether or not the point $A_p$ reaches such a voltage depends upon the relation between the measuring cable length $\ell$ and the wave length of the measurement frequency. That is, a different voltage is measured with a different cable length $\ell$ even if the frequency remains the same. Assuming the separation of $Z_c(\omega)$, the correctness of the calculated value depends upon the CMRR (i.e., Common Mode Rejection Ratio) of the differential amplifier for detecting the value $V_i$. The accuracy of $Z_c(\omega)$ corresponds to a value substantially equal to the CMRR in the worst case. For example, this means a differential amplifier capable of a CMRR of 40 dB or more for 30 MHz for a circuit element measuring apparatus so that the correction data satisfies the separation of the values

$\ell$ and $R_r$ within an accuracy of 1% for 30 MHz. Since it is difficult to manufacture an amplifier having such an excellent CMRR , the correction data $Z_c(\omega)$ must be measured for all the combinations of the cable length $\ell$ and the range resistance $R_r$ and $Z_c(\omega)$ is not independent.

## Summary of the Invention

It is an object of this invention to provide a circuit element measuring apparatus and method capable of a high degree of accuracy.

It is a further object of this invention to provide a circuit element measuring apparatus and method which minimizes the need for storing correction data.

In accordance with these objects, the characteristics of a circuit element or device under test (DUT) is accurately measured through the use of a compensation network according to claims 1 to 9.

In one preferred embodiment, four pairs of cables are connected to the DUT on one end, and the other ends are connected to a signal source, a volt meter, a zero detection amplifier and the compensation network.

In one particularly preferred embodiment, the compensation network comprises a transformer. A winding of the transformer is connected to a detection resistance while another winding of the transformer is connected to the zero detection amplifier. In yet another embodiment, the windings of the transformer are constructed from the core and sheath of a coaxial line.

## Brief Description of the Drawings

Fig. 1 is a schematic diagram of the circuit element measuring apparatus according to the prior art.

Fig. 2 is a schematic diagram of the circuit element measuring apparatus according to one embodiment of the present invention.

Fig. 3 is a schematic diagram of the circuit element measuring apparatus according to one embodiment of the present invention.

Fig. 4 is a diagram showing one embodiment of the transformer $T_1$ of Fig. 3.

Fig. 5 is a schematic diagram showing the case in which the circuit element measuring apparatus of Fig. 3 includes the winding capacity $C_1$ of the transformer $T_1$.

Fig. 6 is a schematic diagram showing the case in which the matching circuit $Z_T$ is added to the circuit element measuring apparatus of Fig. 3.

Fig. 7 is a diagram showing the case in which the transformer $T_1$ of the circuit element measuring apparatus of Fig. 6 has a winding ratio of 1:1.

## Detailed Description of the Preferred Embodiment

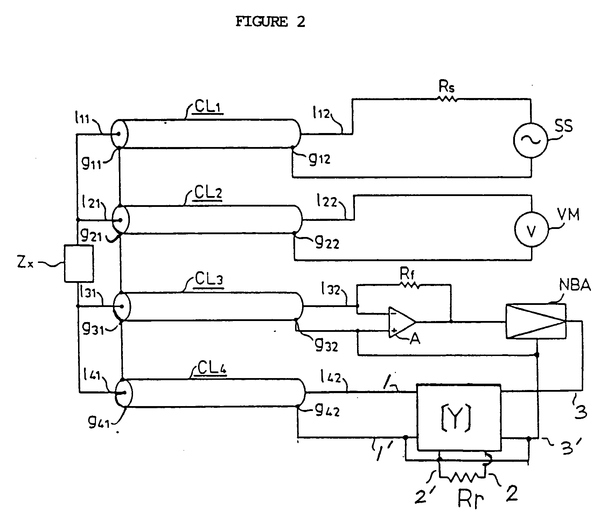

In the circuit element measuring apparatus of Fig. 2, a compensation network [Y] having two-terminal pair ports 1-1', 2-2' and 3-3' is employed in accordance with this invention. The port 1-1' of the compensation network is connected to the terminals $\ell_{42}$ and $g_{42}$; the port 2-2' of the compensation network is connected to the range resistance $R_r$; and the port 3-3' of the compensation network is connected to the output of the NBA.

If the input currents to the ports 1-1', 2-2' and 3-3' are respectively designated as $i_1$, $i_2$ and $i_3$, and if the voltages at the ports 1-1', 2-2' and 3-3' are respectively designated as $v_1$, $v_2$ and $v_3$, the following Equation holds:

$$\begin{bmatrix} i_1 \\ i_2 \\ i_3 \end{bmatrix} = \begin{bmatrix} Y_{11} & Y_{12} & Y_{13} \\ Y_{21} & Y_{22} & Y_{23} \\ Y_{31} & Y_{32} & Y_{33} \end{bmatrix} \begin{bmatrix} v_1 \\ v_2 \\ v_3 \end{bmatrix} \quad \dots \dots (6)$$

wherein the network [Y] has the following Y matrix

$$[Y] = \begin{bmatrix} Y_{11} & Y_{12} & Y_{13} \\ Y_{21} & Y_{22} & Y_{23} \\ Y_{31} & Y_{32} & Y_{33} \end{bmatrix}$$

Moreover, the following two Equations hold:

$$i_1 = -Y_1 v_1 \quad (7)$$

and

$$i_2 = Y_2 v_2 \quad (8)$$

wherein;

$Y_1$ is the admittance looking from the port 1-1′ to the outside; and

$Y_2$ is the admittance looking from the port 2-2′ to the outside.

From the Equations (6) through (8), the following Equations hold:

$$\begin{bmatrix} 0 \\ 0 \\ i \end{bmatrix} = \begin{bmatrix} Y_{11}+Y_1 & Y_{12} & Y_{13} \\ Y_{21} & Y_{22}+Y_2 & Y_{23} \\ Y_{31} & Y_{32} & Y_{33} \end{bmatrix} \begin{bmatrix} v_1 \\ v_2 \\ v_3 \end{bmatrix}$$

$$\cdots\cdots(9)$$

and

$$\frac{v_2}{v_1} = \frac{\begin{vmatrix} Y_{11}+Y_1 & 0 & Y_{13} \\ Y_{21} & 0 & Y_{23} \\ Y_{31} & i_3 & Y_{33} \end{vmatrix}}{\begin{vmatrix} 0 & Y_{12} & Y_{13} \\ 0 & Y_{22}+Y_2 & Y_{23} \\ i_3 & Y_{32} & Y_{33} \end{vmatrix}}$$

$$= \frac{Y_{21}Y_{13} - Y_{23}(Y_{11} + Y_1)}{Y_{12}Y_{13} - Y_{13}(Y_{22} + Y_2)} \quad \cdots\cdots(10).$$

If, moreover the relations between $v_1$ and $I_x$ and between $v_2$ and $v_i$ can be expressed by:

$$I_x = f \cdot v_1 \text{ (f is a function of } \ell) \quad (11);$$

and

$$v_i = g \cdot v_2 \text{ (g is a function of } R_r) \quad (12);$$

the following Equation can be obtained from the Equations (10) through (12):

$$\frac{v_1}{I_x} = \frac{g \cdot [y_{21}y_{13} - y_{23}(y_{11} + Y_1)]}{f \cdot [y_{12}y_{23} - y_{13}(y_{22} + Y_2)]} \quad (13)$$

If $Z_1$ and $Z_2$ are expressed by the following equations, the former is the function of $\ell$ only, and the latter is the function of $R_r$ only:

$$Z_1 = \frac{y_{21}y_{13} - y_{23}(y_{11} + Y_1)}{f} \quad (14)$$

and

$$Z_2 = \frac{g}{y_{12}y_{23} - y_{13}(y_{22} + Y_2)} \quad (15)$$

If the Equations (13), (14) and (15) are substituted into the Equation (2), the following Equation is obtained:

$$1/y(\omega) = V_1/I_x = Z_1(\ell,\omega) Z_2(R_r,\omega) \quad (16)$$

Since, moreover, $H(\omega)$ is not the function of the range resistance $R_r$, the following Equation is obtained if the Equation (16) is substituted into the Equation (3-1):

$$Z_c(\omega) = H(\ell,\omega) Z_1(\ell,\omega) Z_2(R_r,\omega)$$
$$= Z_1{}'(\ell,\omega) Z_2(R_r,\omega) \quad (17)$$

wherein

$$Z_1{}'(\ell,\omega) = H(\ell,\omega) Z_1(\ell,\omega) \quad (17 - 1).$$

Since the relations of the Equations (11) and (12) are generally satisfied in the measuring state, the Equation (17-1) always holds at the measuring state.

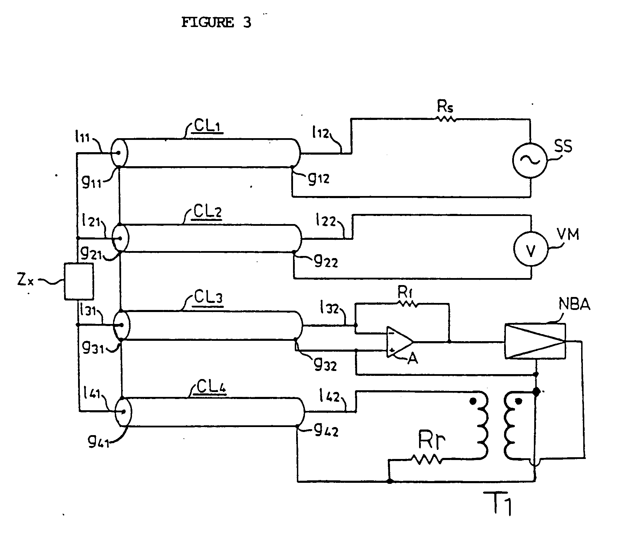

Fig. 3 shows an embodiment in which the compensation network [Y] comprises a transformer $T_1$. The range resistance $R_r$ was one terminal grounded to the earth, and the other terminal connected to the terminal $\ell_{42}$ through one winding of the transformer $T_1$. The other winding of the transformer $T_1$ is connected between the output of the NBA and the earth. The polarity of the winding of the transformer $T_1$ is so selected according to the NBA polarity that the circuit element measuring apparatus may correctly operate.

The circuit in Fig. 2 is comparable to the circuit in Fig. 3 since the range resistance $R_r$ is interchangeable with one winding of the transformer $T_1$ in Fig. 3. Different shields surrounding the transformer $T_1$ and the range resistance $R_r$ may make the $Z_c(\omega)$ more independent.

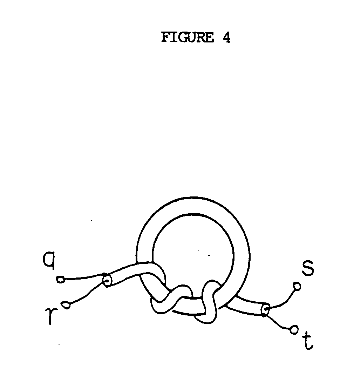

In one preferred embodiment of this invention, the transformer $T_1$ has excellent high-frequency characteristics which can be implemented by winding a coaxial line on the magnetic core as shown in Fig. 4 such that the first and second windings of the transformer are the core and sheath of a coaxial line. Since the range resistance $R_r$ has one terminal grounded to the earth, the differential amplifier is not necessary for detecting the voltage $v_i$.

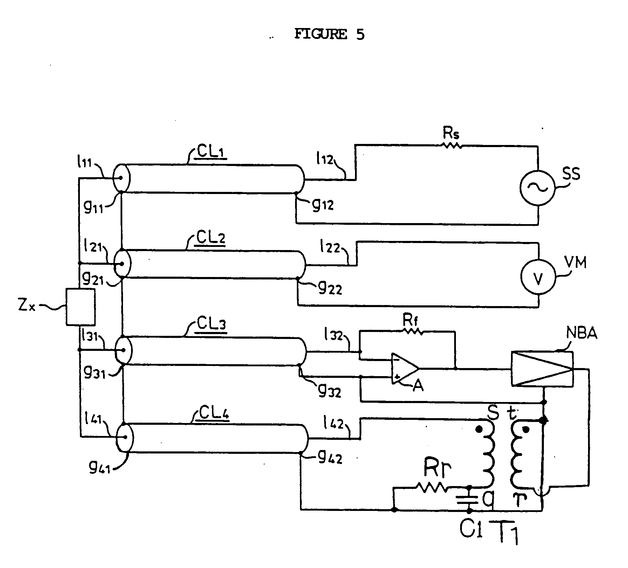

Fig. 5 shows the case in which the transformer $T_1$ has a winding capacitance $C_1$. As the frequency increases, the measurement value at the point q in Fig. 5 becomes more susceptible to the influences of the winding capacitance $C_1$ on the stability of the measurement value. Since the point q is located at one terminal of the winding of the transformer, it is difficult to eliminate the influence of the capacitance $C_1$ of the transformer. The capacitance of $C_1$ in Fig. 5 can, however, be reduced to substantially zero by using the transformer $T_1$ having the structure shown in Fig. 4. Therefore, the structure using the coaxial line is preferred even though the transformer $T_1$ can be implemented in various ways.

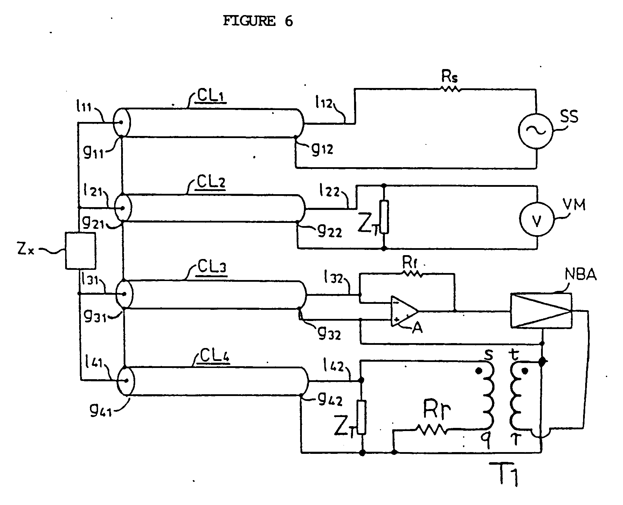

Fig. 6 shows an equivalent circuit when the present invention is practiced with the matching circuit $Z_T$ which is disclosed in Japanese Patent Application Nos. Sho 63-167061 and Hei 01-131050. Under this arrangement, a remote element measurement can be also performed with a high frequency signal without deteriorating the separation of $Z_c(\omega)$.

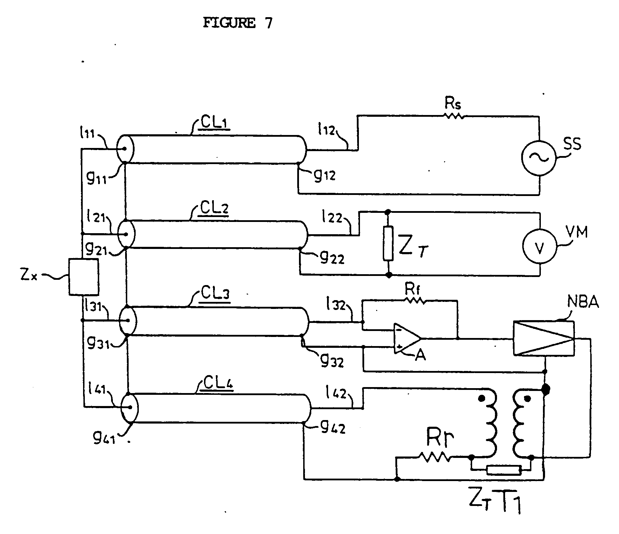

Fig. 7 shows that the winding ratio of the transformer $T_1$ of Fig. 6 is 1:1. Since similar results are obtained, regardless of whether the matching circuit $Z_T$ might be between the points s and t or the points q and r when the winding ratio of the transformer $T_1$ is 1:1, a more complete matching can be obtained by using the winding of the transformer $T_1$ as the line of the characteristic impedance $Z_r$. As a result, the detecting characteristics of the $I_x$ are widened.

According to the practice of the present invention, the unbalanced circuit can obtain substantially accurate measurements of the high frequency voltage/current signal applied to the DUT. Inaccuracies might otherwise be caused by the common mode rejection ratio accompanying the differential detection. Although correction data $Z_c(\omega)$ is a function of the function of the cable length $\ell$ and the function of the range resistor $R_r$, calibration is obtained by the reduced number of the stored correction data $Z_c(\omega)$ because of the separation. More specifically, in the prior art the number of the correction data to be stored is (the number of the cable length $\ell$) x (the number of the range resistors $R_r$). In accordance with the practice of the present invention, correction data stored is reduced to (the number of the cable length $\ell$) + (the number of the range resistors $R_r$) -1.

In the embodiment of the present invention with the coaxial cable wound on the magnetic core, the matching of the circuits can be accomplished, and the influence of the winding capacitance of the transformer can be substantially reduced to widen the range without any deterioration of the aforementioned separation.

## Claims

1. A circuit element measuring apparatus for measuring a parameter of a DUT having one terminal and another terminal, said apparatus comprising:

   a signal source (SS) for generating a measurement voltage;

   a volt meter (VM) for detecting said measurement voltage;

   a zero detection amplifier (A);

   a compensation network (Y) and a range resistance ($R_r$) coupled thereto, said network (Y) having known admittance characteristics;

   a first shielded line ($CL_1$) having one end connected to said one terminal of said DUT and another end of said first line connected to said signal source (SS) for applying said measurement voltage signal to said one terminal;

   a second shielded line ($CL_2$) having one end connected to said one terminal of said DUT and the other end of said second line connected to said volt meter (VM) for detecting said measurement voltage; and

   a third shielded line ($CL_3$) having one end connected to the other terminal of said DUT and the other end of said third line connected to said zero detection amplifier (A) for detecting the voltage at said other terminal;

   a fourth line ($CL_4$) having one end connected to the other terminal of said DUT and the other end of said fourth line connected to said range resistance ($R_r$) and said compensation network (Y) for reducing the voltage at the other terminal of said DUT in response to the output of said zero detection amplifier (A); characterized by

   said compensation network (Y) being coupled to said fourth line ($CL_4$) and said range resistor ($R_r$) so that a first and second set of correction data related to an impedance of the apparatus can be generated, the first set being dependent upon the length of the fourth line ($CL_4$) and independent of the resistance of the range resistor ($R_r$) and the second set being dependent on the resistance of the range resistor ($R_r$) and independent of the length of the fourth line ($CL_4$), said measured value of said parameter being adjusted by the correction data.

2. Apparatus according to Claim 1 wherein the compensation network (Y) includes a transformer ($T_1$) comprising:

   a first winding having one end connected to said fourth line ($CL_4$) and the other end connected to said range resistor ($R_r$); and

   a second winding connected to the output of said zero detection amplifier (A).

3. Apparatus according to Claim 2 wherein said first and second windings are the core and sheath of a coaxial line.

4. Apparatus according to Claim 3 wherein said volt meter (VM) has its input terminating at the characteristic impedance of said second line ($CL_2$), the characteristic impedance of said coaxial line is equal to that of said fourth line ($CL_4$), and the other terminal of said DUT connected to said range resistance ($R_r$) terminates in the characteristic impedance of said fourth line ($CL_4$).

5. Apparatus according to Claim 1 wherein said range resistance ($R_r$) includes one terminal connected to ground.

6. A circuit element measuring apparatus for measuring a parameter of a device under test comprising:

   means (SS) for applying a measurement voltage to one terminal of said device;

   means (VM) for detecting said measurement voltage applied to said one terminal of said device;

   zero detection amplifier (A) means coupled to the other terminal of said device for detecting the voltage at said other terminal;

   range resistance ($R_r$) coupled to said other terminal of said device and said zero detection amplifier (A);

   shielded line means ($CL_1$, $CL_2$, $CL_3$) coupling said device, said means for applying a measurement voltage, said means (VM) for detecting the measurement voltage, said zero detection amplifier (A), and said range resistance ($R_r$);

   compensation means (Y) having known admittance characteristics and being coupled to said range resistance ($R_r$), said zero detection amplifier (A), and said other terminal of said device for reducing the voltage at said other terminal in response to the output of said zero detection amplifier (A); characterized by

said compensation means (Y) and said range resistance ($R_r$) being coupled to said other terminal by one shielded line means ($CL_4$) having a known length so that a first and second set of correction data related to an impedance of the apparatus can be generated, the first set being dependent upon the length of the one shielded line means ($CL_4$) and independent of the resistance of the range resistance ($R_r$), the second set being dependent upon the resistance of the range resistor ($R_r$) and independent of the length of the one shielded line means ($CL_4$), said measured value of said parameter being adjusted by the correction data.

7. Apparatus according to Claim 6 wherein said compensation network (Y) comprises a transformer ($T_1$).

8. A method operating a circuit element measuring apparatus for a device under test having one terminal and another terminal comprising a source of a measurement voltage (SS), means for detecting the measurement voltage (VM), a zero detector amplifier (A), a range resistance ($R_r$), a compensation network (Y) having known admittance characteristics and shielded lines ($CL_1$, $CL_2$, $CL_3$, $CL_4$) coupled thereto, said method comprising the following steps:

applying a measurement voltage from said source (SS) to said one terminal;

detecting the measurement voltage applied to said one terminal by said means for detecting the measurement voltages (VM);

detecting the voltage at said other terminal with said zero detection amplifier (A);

coupling the output of the zero detection amplifier (A) and voltage at said other terminal to said range resistance ($R_r$) and said compensation network (Y) such that said compensation network (Y) tends to reduce the voltage of the other terminal in response to the output of said zero detection amplifier (A); characterized by

generating a first and second set of correction data related to an impedance of said apparatus, said first set being dependent on a length of at least one of the shielded lines ($CL_4$) and independent of the resistance of the range resistance ($R_r$), the second set being dependent on the resistance of the range resistance ($R_r$) and independent of the length of at least one shielded line ($CL_4$);

measuring a parameter of the device under test based on a ratio of said detected voltages; and

adjusting said measured value of said parameter using said correction data.

9. The method of Claim 8 including the step of grounding said range resistance ($R_r$).

## Patentansprüche

1. Eine Schaltungselement-Meßvorrichtung zum Messen eines Parameters eines Meßobjektes, das einen Anschluß und einen anderen Anschluß aufweist, wobei die Vorrichtung folgende Merkmale aufweist:

eine Signalquelle (SS) zum Erzeugen einer Meßspannung;

ein Voltmeter (VM) zum Erfassen der Meßspannung;

einen Null-Erfassungsverstärker (A);

ein Kompensationsnetzwerk (Y) und einen Bereichswiderstand ($R_r$), der an dasselbe gekoppelt ist, wobei das Netzwerk (Y) bekannte Admittanz-Charakteristika aufweist;

eine erste abgeschirmte Leitung ($CL_1$), die ein Ende aufweist, das mit dem einen Anschluß des Meßobjektes verbunden ist, und wobei ein anderes Ende dieser ersten Leitung mit der Signalquelle (SS) zum Anlegen des Meßspannungssignals an den einen Anschluß verbunden ist;

eine zweite abgeschirmte Leitung ($CL_2$), die ein Ende aufweist, das mit dem einen Anschluß des Meßobjektes verbunden ist, und wobei das andere Ende dieser zweiten Leitung mit dem Voltmeter (VM) zum Erfassen der Meßspannung verbunden ist; und

eine dritte abgeschirmte Leitung ($CL_3$), die ein Ende aufweist, das mit dem anderen Anschluß des Meßobjektes verbunden ist, und wobei das andere Ende der dritten Leitung mit dem Null-Erfassungsverstärker (A) zum Erfassen der Spannung an dem anderen Anschluß verbunden ist;

eine vierte Leitung ($CL_4$), die ein Ende aufweist, das mit dem anderen Anschluß des Meßobjektes verbunden ist, wobei das andere Ende der vierten Leitung mit dem Bereichswiderstand ($R_r$) und dem Kompensationsnetzwerk (Y) zum Reduzieren der Spannung an dem anderen Anschluß des Meßobjektes als Reaktion auf die Ausgabe des Null-Erfassungsverstärkers (A) verbunden ist;

dadurch gekennzeichnet, daß

das Kompensationsnetzwerk (Y) mit der vierten Leitung (CL$_4$) und dem Bereichswiderstand (R$_r$) gekoppelt ist, derart, daß ein erster und zweiter Satz von Korrekturdaten, die zu einer Impedanz der Vorrichtung gehören, erzeugt werden können, wobei der erste Satz von der Länge der vierten Leitung (CL$_4$) abhängt und von dem Widerstand des Bereichswiderstands (R$_r$) unabhängig ist, und wobei der zweite Satz von dem Widerstand des Bereichswiderstands (R$_r$) abhängig ist und von der Länge der vierten Leitung (CL$_4$) unabhängig ist, wobei der gemessene Wert des Parameters durch die Korrekturdaten eingestellt wird.

2. Vorrichtung gemäß Anspruch 1, bei der das Kompensationsnetzwerk (Y) einen Transformator (T$_1$) mit folgenden Merkmalen aufweist:
einer ersten Wicklung, die ein Ende aufweist, das mit der vierten Leitung (CL$_4$) verbunden ist, wobei das andere Ende mit dem Bereichswiderstand (R$_r$) verbunden ist; und
einer zweiten Wicklung, die mit dem Ausgang des Null-Erfassungsverstärkers (A) verbunden ist.

3. Vorrichtung gemäß Anspruch 2, bei der die erste und zweite Wicklung die Kabelseele und der Kabelmantel einer Koaxialleitung sind.

4. Vorrichtung gemäß Anspruch 3, bei der das Voltmeter (VM) aufweist, daß der Eingang desselben mit der charakteristischen Impedanz der zweiten Leitung (CL$_2$) abgeschlossen ist, wobei die charakteristische Impedanz der Koaxialleitung gleich der der vierten Leitung (CL$_4$) ist, und wobei der andere Anschluß des Meßobjektes, das mit dem Bereichswiderstand (R$_r$) verbunden ist, mit der charakteristischen Impedanz der vierten Leitung (CL$_4$) abgeschlossen ist.

5. Vorrichtung gemäß Anspruch 1, bei der der Bereichswiderstand (R$_r$) einen Anschluß aufweist, der mit der Masse verbunden ist.

6. Eine Schaltungselement-Meßvorrichtung zum Messen eines Parameters eines Meßobjekts mit folgenden Merkmalen:
einer Einrichtung (SS) zum Anlegen einer Meßspannung an einen Anschluß des Meßobjekts;
einer Einrichtung (VM) zum Erfassen der Meßspannung, die an den einen Anschluß des Meßobjekts angelegt ist;
einer Null-Erfassungsverstärkereinrichtung (A), die mit dem anderen Anschluß des Meßobjekts zum Erfassen der Spannung an dem anderen Anschluß gekoppelt ist;
einem Bereichswiderstand (R$_r$), der mit dem anderen Anschluß des Meßobjekts und dem Null-Erfassungsverstärker (A) gekoppelt ist;
einer abgeschirmten Leitungseinrichtung (CL$_1$, CL$_2$, CL$_3$), die das Meßobjekt, die Einrichtung zum Anlegen einer Meßspannung, die Einrichtung (VM) zum Erfassen der Meßspannung, den Null-Erfassungsverstärker (A) und den Bereichswiderstand (R$_r$) koppelt;
einer Kompensationseinrichtung (Y) mit bekannten Admittanz-Charakteristika, welche mit dem Bereichswiderstand (R$_r$), dem Null-Erfassungsverstärker (A) und dem anderen Anschluß des Meßobjekts zum Reduzieren der Spannung an dem anderen Anschluß als Reaktion auf die Ausgabe des Null-Erfassungsverstärkers (A) gekoppelt ist;
dadurch gekennzeichnet, daß
die Kompensationseinrichtung (Y) und der Bereichswiderstand (R$_r$) mit dem anderen Anschluß durch eine abgeschirmte Leitungseinrichtung (CL$_4$), die eine bekannte Länge aufweist, derart gekoppelt sind, daß ein erster und zweiter Satz von Korrekturdaten, die zu einer Impedanz der Vorrichtung gehören, erzeugt werden können, wobei der erste Satz von der Länge der einen abgeschirmten Leitungseinrichtung (CL$_4$) abhängt und von dem Widerstand des Bereichswiderstands (R$_r$) unabhängig ist, wobei der zweite Satz von dem Widerstand des Bereichswiderstands (R$_r$) abhängt und von der Länge der einen abgeschirmten Leitungseinrichtung (CL$_4$) unabhängig ist, wobei der gemessene Wert des Parameters durch die Korrekturdaten eingestellt wird.

7. Vorrichtung gemäß Anspruch 6, bei der das Kompensationsnetzwerk (Y) einen Transformator (T$_1$) aufweist.

8. Ein Verfahren, das eine Schaltungselement-Meßvorrichtung für ein Meßobjekt betreibt, das einen Anschluß und einen anderen Anschluß aufweist, wobei dieselbe eine Meßspannungsquelle (SS), eine Einrichtung zum Erfassen der Meßspannung (VM), einen Null-Erfassungsverstärker (A), einen Bereichswiderstand (R$_r$), ein Kompensationsnetzwerk (Y) mit bekannten Admittanz-Charakteristika und abgeschirmte Leitungen (CL$_1$, CL$_2$, CL$_3$, CL$_4$) aufweist, die mit derselben gekoppelt sind, wobei das Verfahren folgende Schritte aufweist:

Anlegen einer Meßspannung von der Quelle (SS) an den einen Anschluß;

Erfassen der Meßspannung, die an den einen Anschluß angelegt ist, durch die Einrichtung zum Erfassen der Meßspannung (VM);

Erfassen der Spannung an dem anderen Anschluß mit dem Null-Erfassungsverstärker (A);

Koppeln der Ausgabe des Null-Erfassungsverstärkers (A) und einer Spannung an dem anderen Anschluß mit dem Bereichswiderstand ($R_r$) und dem Kompensationsnetzwerk (Y), derart, daß das Kompensationsnetzwerk (Y) dazu tendiert, die Spannung des anderen Anschlusses als Reaktion auf die Ausgabe des Null-Erfassungsverstärkers (A) zu reduzieren;

gekennzeichnet durch

Erzeugen eines ersten und zweiten Satzes von Korrekturdaten, die zu einer Impedanz der Vorrichtung gehören, wobei der erste Satz von einer Länge mindestens einer der abgeschirmten Leitungen ($CL_4$) abhängt und von dem Widerstand des Bereichswiderstandes ($R_r$) unabhängig ist, und wobei der zweite Satz von dem Widerstand des Bereichswiderstandes ($R_r$) abhängt und von der Länge mindestens einer abgeschirmten Leitung ($CL_4$) unabhängig ist;

Messen eines Parameters des Meßobjekts, basierend auf einem Verhältnis der erfaßten Spannungen; und

Einstellen des gemessenen Wertes des Parameters unter Verwendung der Korrekturdaten.

9. Das Verfahren gemäß Anspruch 8, das den Schritt des Erdens des Bereichswiderstandes ($R_r$) aufweist.


**Revendications**

1. Dispositif de mesure d'un élément de circuit servant à mesurer un paramètre d'un dispositif en essai, doté d'une borne et d'une autre borne, comportant :

une source de signal (SS) servant à générer une tension de mesure ;

un voltmètre (VM) servant à détecter la tension de mesure ;

un amplificateur de détection du zéro (A) ;

un réseau correcteur (Y) et une résistance de gamme (Rr) couplée à ce réseau (Y) dont la caractéristique d'admittance est connue ;

une première ligne blindée (CL1) dont une extrémité est reliée à la borne du dispositif en essai et une autre extrémité de la première ligne est reliée à la source de signal (SS) pour appliquer le signal de tension de mesure à cette borne ;

une deuxième ligne blindée (CL2) dont une extrémité est reliée à la borne du dispositif en essai et l'autre extrémité de la deuxième ligne est reliée au voltmètre (VM) pour détecter la tension de mesure et

une troisième ligne blindée (CL3) dont une extrémité est reliée à l'autre borne du dispositif en essai et l'autre extrémité de la troisième ligne est reliée à l'amplificateur de détection du zéro (A) pour détecter la tension présente à l'autre borne ;

une quatrième ligne (CL4) dont une extrémité est reliée à l'autre borne du dispositif en essai et l'autre extrémité de la quatrième ligne est reliée à la résistance de gamme (Rr) et au réseau correcteur (Y) afin d'abaisser la tension à l'autre borne du dispositif en essai en réponse à la sortie de l'amplificateur de détection du zéro (A), caractérisé en ce que

le réseau correcteur (Y) est couplé à la quatrième ligne (CL4) et à la résistance de gamme (Rr) de manière à pouvoir générer un premier et un second jeu de données de correction liées à une impédance du dispositif, en ce que le premier jeu est dépendant de la longueur de la quatrième ligne (CL4) et indépendant de la résistance de la résistance de gamme (Rr) et en ce que le second jeu est dépendant de la résistance de la résistance de gamme (Rr) et indépendant de la longueur de la quatrième ligne (CL4), la valeur mesurée du paramètre étant ajustée par les données de correction.

2. Dispositif selon la revendication 1, dans lequel le réseau correcteur (Y) comprend un transformateur (T1) comportant :

un premier enroulement dont une extrémité est reliée à la quatrième ligne (CL4) et l'autre extrémité est reliée à la résistance de gamme (Rr) et

un second enroulement relié à la sortie de l'amplificateur de détection du zéro (A).

3. Dispositif selon la revendication 2, dans lequel les premier et second enroulements constituent le conducteur et l'enveloppe d'une ligne coaxiale.

4. Dispositif selon la revendication 3, dans lequel l'entrée du voltmètre (VM) est refermée sur l'impédance caractéristique de la deuxième ligne (CL2), l'impédance caractéristique de la ligne coaxiale est égale à celle de la quatrième ligne (CL4) et l'autre borne du dispositif en essai reliée à la résistance de gamme (Rr) est refermée sur l'impédance caractéristique de la quatrième ligne (CL4).

5. Dispositif selon la revendication 1, caractérisé en ce que la résistance de gamme (Rr) comprend une borne reliée à la terre.

6. Dispositif de mesure d'un élément de circuit servant à mesurer un paramètre d'un dispositif en essai, comportant :
   des moyens (SS) d'application d'une tension de mesure à une borne du dispositif ;
   des moyens (VM) de détection de la tension de mesure appliquée à cette borne du dispositif ;
   des moyens d'amplificateur de détection du zéro (A) couplés à l'autre borne du dispositif en vue de détecter la tension présente à cette autre borne ;
   une résistance de gamme (Rr) couplée à l'autre borne du dispositif et à l'amplificateur de détection du zéro (A) ;
   des moyens de lignes blindées (CL1, CL2, CL3) qui couplent le dispositif, les moyens d'application d'une tension de mesure, les moyens (VM) de détection de la tension de mesure, l'amplificateur de détection du zéro (A) et la résistance de gamme (Rr) ;
   des moyens de correction (Y) dotés d'une caractéristique d'impédance connue et couplés à la résistance de gamme (Rr), à l'amplificateur de détection du zéro (A) et à l'autre borne du dispositif afin d'abaisser la tension à l'autre borne en réponse à la sortie de l'amplificateur de détection du zéro (A), caractérisé en ce que
   les moyens de correction (Y) et la résistance de gamme (Rr) sont couplés à l'autre borne par des moyens de ligne blindée (CL4) de longueur connue de manière à pouvoir générer un premier et un second jeu de données de correction liées à une impédance du dispositif, en ce que le premier jeu est dépendant de la longueur du moyen de ligne blindée (CL4) et indépendant de la résistance de la résistance de gamme (Rr), en ce que le second jeu est dépendant de la résistance de la résistance de gamme (Rr) et indépendant de la longueur des moyens de ligne blindée (CL4), la valeur mesurée du paramètre étant ajustée par les données de correction.

7. Dispositif selon la revendication 6, caractérisé en ce que le réseau correcteur (Y) comprend un transformateur (T1).

8. Procédé exploitant un dispositif de mesure d'un élément de circuit destiné à un dispositif en essai possédant une borne et une autre borne, comportant une source de tension de mesure (SS), des moyens de détection de la tension de mesure (VM), un amplificateur de détection du zéro (A), une résistance de gamme (Rr), un réseau correcteur (Y) dont la caractéristique d'impédance est connue et des lignes blindées (CL1, CL2, CL3, CL4) qui y sont couplées, procédé comportant les étapes suivantes :
   application d'une tension de mesure à partir de la source (SS) à la borne ; détection de la tension de mesure appliquée à cette borne par les moyens de détection de la tension de mesure (VM) ;
   détection de la tension à l'autre borne à l'aide de l'amplificateur de détection du zéro (A) ;
   couplage de la sortie de l'amplificateur de détection du zéro (A) et de la tension présente à l'autre borne à la résistance de gamme (Rr) et au réseau correcteur (Y) de sorte que le réseau correcteur (Y) ait tendance à abaisser la tension présente à l'autre borne en réponse à la sortie de l'amplificateur de détection du zéro (A), caractérisé en ce
   qu'il génère un premier et second jeu de données de correction liées à une impédance du dispositif, en ce que le premier jeu est dépendant d'une longueur d'au moins une des lignes blindées (CL4) et indépendant de la résistance de la résistance de gamme (Rr), en ce que le second jeu est dépendant de la résistance de la résistance de gamme (Rr) et indépendant de la longueur d'au moins une ligne blindée (CL4) ;
   qu'il mesure un paramètre du dispositif en essai en se fondant sur un rapport des tensions détectées et
   qu'il ajuste la valeur mesurée du paramètre en recourant aux données de correction.

9. Procédé selon la revendication 8, comprenant l'étape de la mise à la terre de la résistance de gamme (Rr).

FIGURE 1
Prior Art

FIGURE 2

FIGURE 3

FIGURE 4

FIGURE 5

FIGURE 6

FIGURE 7